Europäisches Patentamt

(19) European Patent Office

Office européen des brevets

(11) Numéro de publication: **0 241 447**
**B1**

(12) **FASCICULE DE BREVET EUROPEEN**

(45) Date de publication du fascicule du brevet:
**02.11.89**

(21) Numéro de dépôt: **87870045.9**

(22) Date de dépôt: **03.04.87**

(51) Int. Cl.⁴: **H01J 37/34**

(54) Cathode de pulvérisation.

(30) Priorité: **03.04.86 FR 8604789**

(43) Date de publication de la demande:
**14.10.87 Bulletin 87/42**

(45) Mention de la délivrance du brevet:
**02.11.89 Bulletin 89/44**

(84) Etats contractants désignés:
**BE DE ES FR GB IT LU NL**

(56) Documents cités:
**EP-A- 0 014 819**
**WO-A-82/02725**
**US-A- 4 175 030**

(73) Titulaire: **S.A. Glaceries de Saint-Roch, Rue des Glaces Nationales, 168, B-5700 Sambreville(BE)**

(72) Inventeur: **Vranken, Jean-Paul, Rue Van Cutsem, 60, B-5790 Jemeppe(BE)**
Inventeur: **Devigne, Roland, Rue de la Montagne, B-5670 Sambreville(BE)**

(74) Mandataire: **Plucker, Guy et al, OFFICE KIRKPATRICK 4 Square de Meeûs, B-1040 Bruxelles(BE)**

ACTORUM AG

## Description

La présente invention concerne un dispositif de pulvérisation cathodique, spécialement conçu pour le recouvrement d'objets de grandes dimensions, tels que, par exemple, des plaques de verre.

La pulvérisation cathodique est une méthode désormais éprouvée pour l'application de couches fines et uniformes d'un matériau de revêtement sur certains substrats. Généralement, on réalise la pulvérisation cathodique au moyen d'une cathode connectée à une source d'électricité, la cathode étant placée dans une enceinte en atmosphère raréfiée, en présence d'un gaz (par exemple, l'argon) dont la nature varie en fonction du revêtement recherché. Une cible réalisée dans le matériau à pulvériser, fixée sur la cathode, est bombardée au moyen d'ions énergétiques, de sorte que des particules du matériau dont est formée la cible sont arrachées de cette dernière. Le substrat à recouvrir est placé dans le trajet de ces particules et il s'y dépose une fine couche du matériau de la cible ou d'un composé chimique de celui-ci formé avec le gaz environnant.

La possibilité de confiner les ions dans le voisinage de la cible à l'aide d'un champ magnétique a fait progresser considérablement cette technique en augmentant de façon substantielle le taux de pulvérisation.

Un type de cathode est décrit dans le brevet américain US-A 3 956 093. On y décrit une cible plane où les dispositifs magnétiques sont disposés de façon à réaliser une zone de confinement en forme de piste ovale.

Ce type de cathode ne permet la pulvérisation que d'un seul côté. Si l'on désire pulvériser de deux côtés à la fois, il est nécessaire de placer deux cathodes accolées dos à dos, ce qui peut entraîner l'emploi de deux alimentations séparées et rend le processus de régulation du dépôt délicat.

Une autre cathode de pulvérisation, pour le recouvrement de substrats de grandes dimensions, est décrite dans le brevet US-A 4 194 962 = EP-A 0 014 819. Dans cette cathode, deux faces de cible parallèles sont raccordées par des faces de pontage afin d'assurer la continuité de la ceinture magnétique de confinement. Cette cathode permet de pulvériser simultanément de deux côtés opposés, mais elle implique une vitesse de pulvérisation relativement faible. Pour accroître la vitesse de croissance du dépôt, on peut placer plusieurs cathodes de ce type côte à côte dans la même enceinte. Ici aussi, des alimentations séparées doivent être utilisées pour obtenir un dépôt homogène et reproductible, ce qui complique fortement le processus de régulation du système.

Le but de l'invention est d'obtenir une cathode de pulvérisation permettant de pulvériser sur des substrats de grandes dimensions, dans des plans distincts avec un taux de pulvérisation élevé, les cibles ne formant qu'une seule piste continue, ce qui simplifie l'alimentation électrique et la régulation du processus et améliore l'uniformité du dépôt.

En effet, avec son taux de pulvérisation élevé, une seule cathode suivant l'invention peut être substituée à plusieurs cathodes classiques, avec l'avantage qu'il ne substiste plus qu'une seule alimentation et un seul système de régulation. Avantage supplémentaire, on évite le risque d'interaction lié à la présence de cathodes différentes situées dans la même enceinte.

Enfin, il a été montré expérimentalement que la régularité des dépôts réalisés avec une cathode suivant l'invention à alimentation unique est nettement supérieure à celle que l'on peut obtenir avec une succession de cathodes classiques qui de surcroît imposent des alimentations et des régulations distinctes.

L'objet de l'invention est une cathode de pulvérisation comprenant:

– une structure de support réalisée en un matériau non magnétique conducteur de l'électricité sur laquelles sont fixées plusieurs bandes de matériau à pulvériser situées dans au moins deux plans distincts, des moyens permettant de connecter la structure de support à une source de courant électrique et des moyens magnétiques situés dans la structure de support, disposés de manière à diriger un champ magnétique dans le voisinage de la surface des bandes de matériau à pulvériser, et sur toute la longueur de celles-ci. Dans chaque plan, au moins deux bandes de matériau à pulvériser sont disposées côte à côte; toutes les bandes de matériau à pulvériser étant raccordées en série par leurs extrémités afin de former une seule piste continue et fermée sur elle-même. Des moyens magnétiques sont disposés à la suite des moyens magnétiques disposés dans les zones de raccord entre les bandes de matériau à pulvériser, de sorte qu'une zone de confinement magnétique continue et fermée sur elle-même se superpose à la piste continue de matériau à pulvériser.

Dans une forme d'exécution préférée de l'invention, dans chaque plan, les bandes de matériau à pulvériser sont dotées chacune de moyens magnétiques distincts des autres bandes de matériau à pulvériser.

Dans une forme d'exécution de l'invention, la cathode de pulvérisation comporte des bandes de matériau à pulvériser situées dans deux plans parallèles, de sorte que deux substrats situés dans deux plans parallèles de part et d'autre de la cathode puissent être recouverts simultanément.

Dans une forme d'exécution préférée de l'invention, les bandes de matériau à pulvériser sont situées dans deux plans sécants, de sorte que deux substrats situés de part et d'autre de la cathode parallèlement aux faces de pulvérisation puissent être recouverts simultanément.

Une forme préférée de l'invention comporte deux bandes de matériau à pulvériser disposées côte à côte dans chaque plan de pulvérisation de la cathode.

Une autre forme de réalisation comporte plus de deux bandes de matériau à pulvériser disposées côte à côte dans chaque plan.

Dans une forme d'exécution possible de l'invention, la cible est constituée de bandes de matériau à pulvériser de différentes natures.

Dans une forme d'exécution particulière de la cathode suivant l'invention, chaque plan de pulvérisation comporte une ou plusieurs bandes de matériau à pulvériser constituées d'un matériau différent de celui des autres bandes.

Dans une forme de réalisation possible, les bandes de matériau formant la cible sont elle-mêmes constituées de plusieurs matériaux différents.

Dans une forme de réalisation avantageuse de l'invention, l'espace entre les faces internes de la cathode est occupé par un matériau (conducteur ou isolant) non magnétique, tel que l'aluminium, afin d'éviter la pulvérisation de la surface arrière du dispositif.

Avantageusement, la cathode suivant l'invention est munie d'un système de refroidissement consistant en un conduit à section fermée accolé à l'élément-cible. Cette conception évite un risque de fuite via les joints d'étanchéité entre le circuit de refroidissement et l'enceinte à vide.

D'autres particularités et avantages de l'invention ressortiront de la description détaillée d'une forme d'exécution préférée, donnée ci-après, à titre d'exemple non limitatif, avec référence aux dessins annexés, dans lesquels :

la Fig. 1 est une vue en perspective d'un type de cathode de pulvérisation suivant l'invention;

la Fig. 2 est une vue en coupe transversale d'une des branches de la cathode de la Fig. 1, suivant la ligne II-II de la Fig. 1;

la Fig. 3 est une vue en coupe longitudinale suivant le ligne III-III de la Fig. 1.

la Fig. 4 est une variante d'exécution de la Fig. 2;

la Fig. 5 est une autre variante d'exécution de la Fig. 2;

la Fig. 6 est une vue transversale schématique d'une partie d'un système de revêtement par pulvérisation cathodique suivant l'invention avec un dispositif d'entraînement des substrats;

la Fig. 7 est une vue en perspective schématique d'une variante d'exécution d'une cathode suivant l'invention, et

les Fig. 8 et 9 sont des vues en perspective schématiques de deux autres variantes d'exécution d'une cathode suivant l'invention.

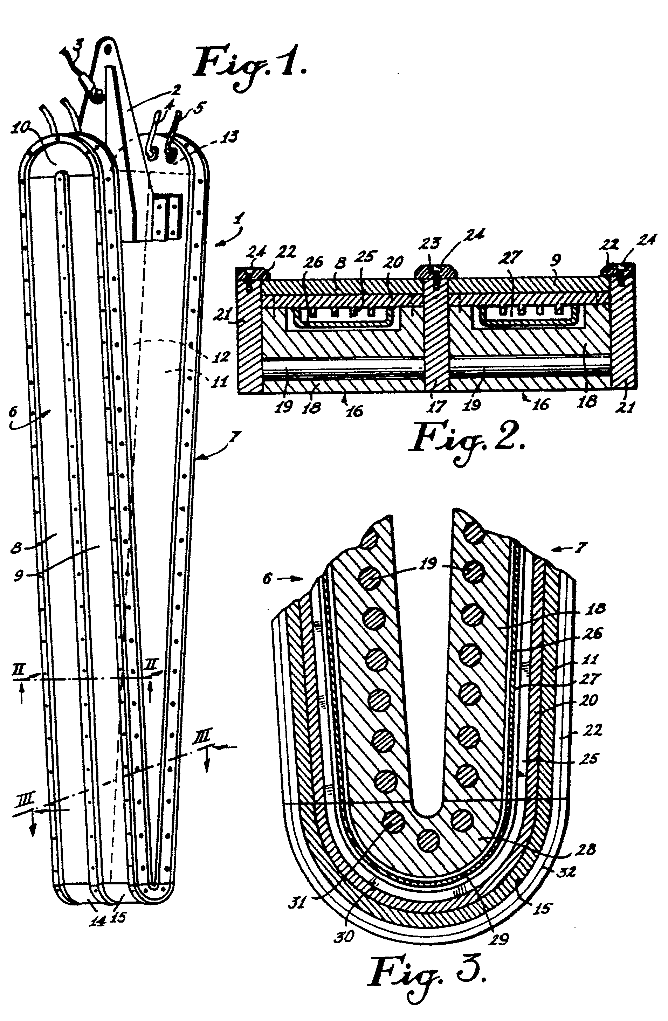

Une cathode de pulvérisation, suivant l'invention, est représentée en perspective à la Fig. 1. La cathode 1 présente, vue de côté, une structure générale en forme de V; elle est munie d'une patte de fixation 2 permettant de la suspendre dans son enceinte de pulvérisation sous vide. La cathode est réalisée en un matériau conducteur de l'électricité et possède un moyen de connexion 3 permettant de la raccorder à une alimentation électrique et des moyens de connexion 4 et 5 permettant de la raccorder à un circuit de refroidissement. Elle présente deux faces extérieures 6 et 7 s'étendant suivant deux plans sécants, chaque face étant munie de dispositifs permettant la fixation aisée de bandes de matériau à pulvériser. Sur la face 6 sont fixées deux bandes longitudinales 8 et 9 raccordées entre elles par l'une de leurs extrémités au moyen d'une bande 10 en arc de cercle. De même, sur la face 7 sont fixées deux bandes longitudinales 11 et 12 raccordées entre elles par l'une de leurs extrémités au moyen d'une bande 13 en arc de cercle. Deux bandes 14 et 15 pliées en forme de U raccordent entre elles les bandes 8 et 12 et les bandes 9 et 11, respectivement, de sorte que l'ensemble des bandes forme une piste continue et fermée sur elle-même s'étandant suivant les deux faces extérieures de la cathode. La cathode comprend des dispositifs magnétiques ainsi qu'un système de refroidissement qui seront décrits en se référant aux Fig. 2 et 3.

La Fig. 2 est une vue en coupe transversale dans l'une des branches de la cathode de la Fig. 1, suivant la ligne II-II. Chaque branche comprend deux parties semblables 16 séparées par une plaque 17. Chaque partie 16 comprend un corps 18 dans lequel sont fixés les dispositifs magnétiques 19, un support de cible 20, une bande 8 ou 9 de matériau à pulvériser, ou cible, une plaque externe 21, des éléments de serrage de cible 22 et 23 fixés à l'ensemble par des vis 24.

Le corps 18 est formé d'un matériau électriquement conducteur non magnétique, par exemple de l'aluminium et est raccordé à l'alimentation électrique. Le support de cible 20 est fixé au corps 18 au moyen de vis et est réalisé en un matériau conducteur non magnétique, par exemple de l'acier inoxydable ou de l'aluminium. Il est muni d'ailettes de refroidissement 25 et d'une tôle soudée 26 en acier inoxydable ou en aluminium formant un espace fermé 27 raccordé aux connexions 4 et 5 dans lesquels circule un agent de refroidissement, par exemple de l'eau. Cet agent de refroidissement est destiné à évacuer l'énergie thermique générée par le processus de bombardement ionique. Les plaqies 17 et 21 ainsi que les éléments de serrage de cible 22 et 23 sont réalisés en un matériau magnétique, tel que de l'acier doux.

La cible de pulvérisation cathodique 8, 9 épouse la forme du support de cible 20, auquel elle est fixée au moyen des éléments de serrage et de confinement magnétique 22 et 23, d'une manière assurant un bon contact électrique avec le support de cible 20 et le corps 18, de sorte que la cible se trouve à la tension de la borne négative de l'alimentation électrique.

Les dispositifs magnétiques 19, qui sont ici constituées par des aimants permanents cylindriques, ont leurs extrémités supportées par les plaques 17 et 21, tous les aimants dans un corps 16 ayant leurs pôles alignés dans un sens, tous les aimants dans le corps 16 adjacent ayant leurs pôles alignés en sens inverse, de sorte que la plaque 17 est en contact avec le pôle de même signe de tous les aimants, les plaques 21 étant en contact avec les pôles de l'autre signe. Etant donné la nature des matériaux utilisés pour les plaques 17 et 21, ainsi que pour les éléments de serrage 22 et 23 et pour la cible, les lignes de flux magnétique se referment entre les éléments de serrage 22 et 23, dans le voisinage de la cible, ce qui crée une zone de confinement des ions positifs formés au niveau de la cible dans le plasma sous la forme d'un tunnel en arc de cercle.

La Fig. 3 représente une vue en coupe longitudinale dans la cathode suivant l'invention, montrant la zone de raccord entre les deux faces 6 et 7. Chaque élément de la face 6, à savoir le corps 18, le support de cible 20 et la cible 8, est raccordé à l'élément correspondant de la face 7, d'une manière assurant la continuité électrique entre les éléments correspondants des deux faces. Les corps 18 sont raccordés entre eux par un corps 28 en forme de U, les tôles soudées 26 sont raccordées entre elles par une tôle 29 reliant entre eux les espaces fermés 27 dans lesquels circule l'agent de refroidissement, les supports de cible 20 sont raccordés entre eux par un élément 30 en forme de U et les cibles 9 et 11 sont raccordées entre elles par un élément 15 en forme de U.

Le corps 28, réalisé en un matériau similaire à celui des corps 18, comprend des dispositifs magnétiques 31, qui sont ici constitués par des aimants permanents cylindriques, de sorte que des lignes de flux magnétique se referment dans le voisinage des éléments 14 et 15, raccordant entre elles les zones de confinement magnétique des faces 6 et 7, pour former une seule zone de confinement continue se superposant à la piste continue des bandes de matériau à pulvériser.

Les éléments 30, en forme de U, sont réalisés en un matériau similaire à celui des supports de cible 20 et sont munis comme ces derniers d'ailettes de refroidissement.

Les éléments de cible 14 et 15 réalisés dans le même matériau que les éléments de cible 8, 9, 11, 12 sont fixés au support de cible 30 au moyen d'éléments de serrage 32, en forme de U, d'une manière assurant un bon contact électrique avec le support de cible 30 et le corps 28, de sorte que les éléments de cible 14 et 15 se trouvent à la tension de la borne négative de l'alimentation électrique.

Il est évident que la pulvérisation se produit également au niveau des éléments de cible 14 et 15. Une cathode suivant l'invention permet ainsi de métalliser de façon homogène des substrats courbes se déplaçant devant des parties de cible de forme courbe, adaptée à celle des substrats à métalliser.

La Fig. 4 est une variante d'exécution de la Fig. 2, dans laquelle les dispositifs magnétiques, constitués ici d'aimants permanents cylindriques 33, sont fixés dans un plan perpendiculaire aux cibles 5, 6, au moyen des plaques 34 réalisées en un matériau conducteur non magnétique, par exemple de l'aluminium. Tous les aimants ont leurs pôles alignés dans un même sens, les éléments de serrage 22 étant en contact avec tous les pôles de même signe, tandis que la plaque 35 est en contact avec tous les pôles de l'autre signe. La plaque 35 est réalisée en un matériau magnétique, tel que l'acier doux. C'est également le cas des éléments de serrage 22 et 23. Par contre, les corps 18, les éléments 36 et les supports de cible 20 sont réalisés en matériaux conducteurs non magnétiques, de sorte que des lignes de flux magnétique se referment entre les éléments de serrage 22 et 23, dans le voisinage de la cible, d'une manière similaire à celle de la Fig. 2.

La Fig. 5 représente une autre variante d'exécution de la Fig. 2, dans laquelle des dispositifs magnétiques, 37, 38, 39, 40, constitués d'aimants permanents cylindriques sont disposés perpendiculairement au plan des cibles 8 et 9, comme dans la Fig. 4, mais de part et d'autre de chaque bande de cible.

Tous les aimants 37 et 40 ont leurs pôles alignés dans le même sens, tandis que tous les aimants 38 et 39 ont leurs pôles alignés dans l'autre sens, afin de produire au travers de la plaque 41 et des éléments de serrage 22 un champ magnétique qui se referme dans le voisinage de la cible, d'une manière similaire à celle de la Fig. 2.

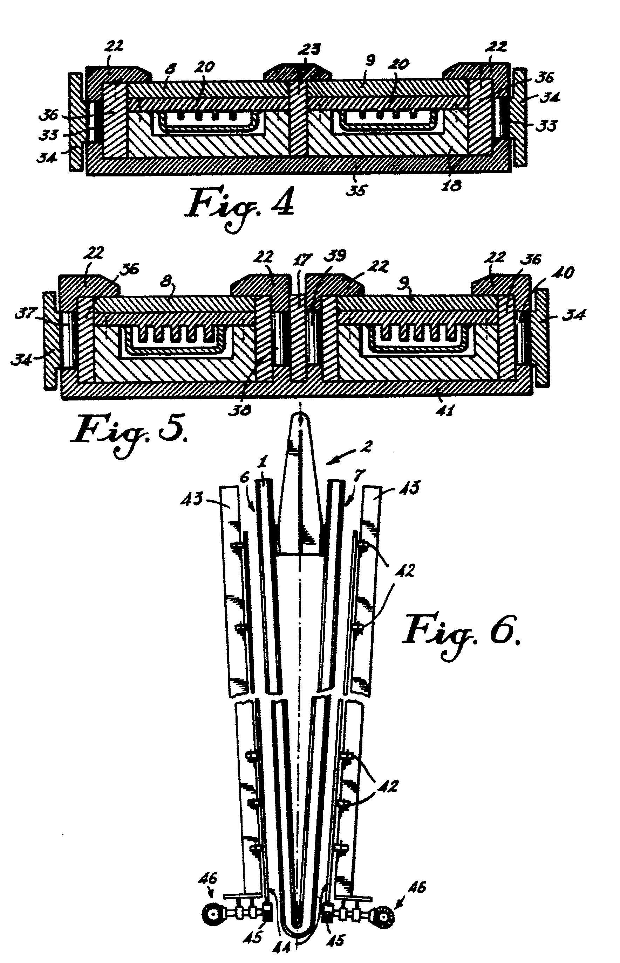

La Fig. 6 représente la cathode de la Fig. 1 avec les substrats et les dispositifs permettant le déplacement des substrats. La cathode 1 est fixée verticalement, de sorte que ses deux faces de pulvérisation 6 et 7 sont inclinées d'un même angle de part et d'autre d'un plan vertical. Des roulettes 42 solidaires des supports 43 parallèles aux faces 6 et 7 forment de part et d'autre de la cathode deux faces d'appui sur lesquelles sont disposés les substrats 44, par exemple des plaques de verre de grandes dimensions. L'arête inférieure des substrats repose sur des roulettes 45. Un dispositif de commande 46, constitué d'une série de renvois d'angles à engrenages, met en rotation les roulettes 45, de sorte que les substrats se déplacent suivant un mouvement de translation dans deux plans parallèles aux faces de pulvérisation 6 et 7. La longueur des faces de pulvérisation est telle qu'elles dépassent les bords supérieurs et inférieurs des substrats afin d'assurer un revêtement uniforme des substrats sur toute leur hauteur, y compris les extré mités inférieures et supérieures.

Un avantage de la cathode suivant la Fig. 6 réside dans l'inclinaison des faces 6 et 7, par rapport à la verticale; les substrats peuvent être simplement posés sur les roulettes motrices 45 en s'appuyant sur les roulettes libres 42; aucun moyen de fixation des substrats n'est donc nécessaire, ce qui permet de recouvrir ces derniers sur l'entièreté de leur surface, sans qu'aucune partie ne soit masquée par des moyens de fixation.

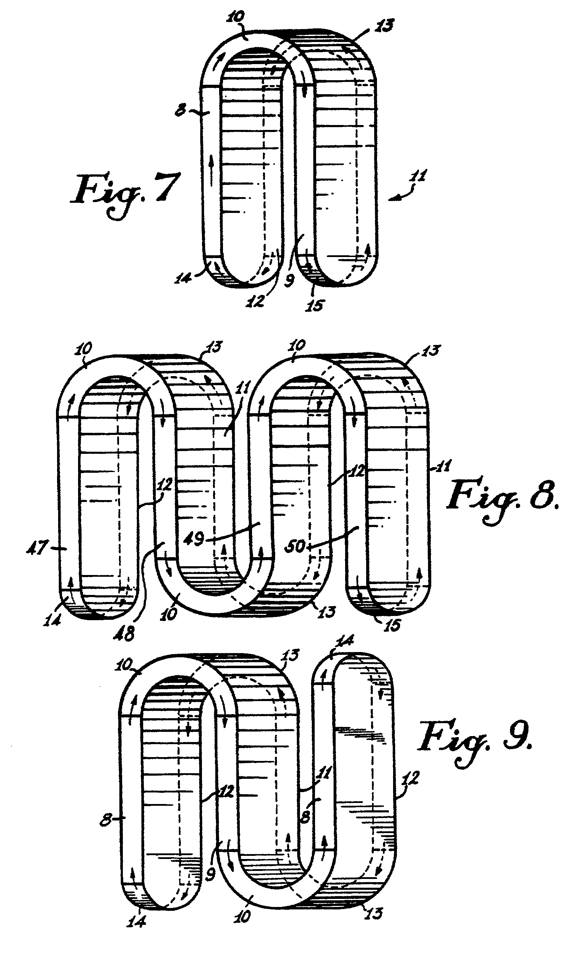

La Fig. 7 représente schématiquement une cathode suivant l'invention, dont les deux faces de pulvérisation sont situées dans deux plans parallèles, chacune étant constituée de deux bandes de cible raccordées entre elles par l'une de leurs extrémités, les extrémités restées libres dans chaque plan étant raccordées entre elles afin de former une seule piste fermée et continue.

La Fig. 8 représente schématiquement une forme d'exécution différente. La cathode comprend deux faces de pulvérisation situées dans deux plans parallèles, chacune d'elles étant constituée en l'occurrence de quatre bandes de cible contiguës raccordées entre elles par leurs extrémités afin de former dans chaque plan une piste unique ouverte à ses deux extrémités, les pistes ainsi formées dans les deux plans de pulvérisation étant raccordées entre elles par leurs extrémités libres correspondantes afin de former une seule piste fermée et continue.

La cathode telle qu'illustrée schématiquement à la Fig. 8 montre bien la possibilité qu'offre l'invention d'obtenir des faces de pulvérisation pouvant s'étendre dans les deux directions, par l'adjonction de bandes de matériau à pulvériser, tout en conservant une piste unique continue dépendant d'un seul circuit d'alimentation électrique.

La Fig. 9 montre une autre réalisation possible d'une cathode suivant l'invention et dotée d'un nombre impair de bandes-cibles dans chaque plan.

On notera que la cible peut être constituée de bandes successives de natures différentes. Du fait de la configuration de la cathode selon l'invention, on peut faire défiler un substrat devant des tronçons de cible pulvérisant des matériaux distincts, et le revêtir ainsi, en un seul passage, de couches successives et distinctes de matériaux, et ce avec une seule alimentation et donc un seul système de régulation.

On peut déposer avec une même cathode autant de couches distinctes qu'il y a de bandes disposées par face. Ainsi, la cathode décrite à la Fig. 8 permet de pulvériser, en un seul passage, quatre couches de matériaux sur un même substrat. Du cuivre, par exemple, en passant devant les éléments 47 et 48 de la cible, puis de l'argent pulvérisé à partir de l'élément de cible 49 et enfin de l'or à hauteur de l'élément 50.

Bien entendu, l'invention n'est en aucune manière limitée aux formes d'exécution représentées et décrites ci-dessus, auxquelles de nombreuses variantes et modifications peuvent être apportées sans sortir de son cadre.

**Revendications**

1. Cathode de pulvérisation (1) comprenant une structure (18, 20) réalisée en un matériau non magnétique conducteur de l'électricité sur laquelle sont fixées plusieurs bandes (8, 9, 11, 12) de matériau à pulvériser situées dans au moins deux plans distincts, des moyens (3) permettant de connecter la cathode (1) à une source de courant électrique, et des moyens magnétiques (17, 19, 21, 22, 23) disposés de manière à ce que le champ magnétique engendré se referme dans le voisinage de la surface des bandes (8, 9, 11, 12) de matériau à pulvériser sur toute la longueur de celles-ci, caractérisée en ce que dans chaque plan, au moins deux bandes (8, 9) de matériau à pulvériser sont disposées côte à côte, toutes les bandes de matériau à pulvériser (8, 9, 11, 12) étant raccordées en série par leurs extrémités, de façon à obtenir une seule piste continue et fermée (8, 9, 10, 11, 12, 13, 14, 15), des moyens magnétiques (17, 19, 21, 22, 23, 31) étant disposés dans les zones de raccord entre les bandes (8, 9, 11, 12) de matériau à pulvériser, de sorte qu'une zone de confinement magnétique continue se superpose à la piste continue (8, 9, 10, 11, 12, 13, 14, 15) de matériau à pulvériser.

2. Cathode de pulvérisé suivant la revendication 1, caractérisé en ce que les bandes (8, 9, 11, 12) de matériau à pulvériser sont dotées chacune de moyens magnétiques (17, 19, 21, 22, 23) distincts des moyens magnétiques (17, 19, 21, 22, 23) des autres bandes (8, 9, 11, 12) de matériau à pulvériser.

3. Cathode de pulvérisation suivant l'une quelconque des revendications 1 et 2, caractérisée en ce que les bandes (8, 9, 11, 12) de matériau à pulvériser sont situées dans deux plans parallèles.

4. Cathode de pulvérisation suivant l'une quelconque des revendications 1 et 2, caractérisée en ce que les bandes (8, 9, 11, 12) de matériau à pulvériser sont situées dans deux plans sécants.

5.- Cathode de pulvérisation suivant l'une quelconque des revendications précédentes, caractérisée en ce que deux bandes (8, 9) de matériau à pulvériser sont disposées dans chaque plan.

6.- Cathode de pulvérisation suivant, l'une quelconque des revendications 1 à 4, caractérisée en ce que plus de deux bandes (8, 9) de matériau à pulvériser sont disposées dans chaque plan.

7.- Cathode de pulvérisation suivant l'une quelconque des revendications précédentes, caractérisée en ce qu'elle comporte une ou plusieurs bandes (47, 48, 49, 50) de matériau à pulvériser constituées d'un matériau différent de celui des autres bandes (8, 9, 11, 12).

8.- Cathode de pulvérisation suivant l'une quelconque des revendications 1 à 6, caractérisée en ce qu'elle comporte dans chaque plan une ou plusieurs bandes (47, 48, 49, 50) de matériau à pulvériser constituées d'un matériau différent de celui des autres bandes (8, 9, 11, 12).

9.- Cathode de pulvérisation suivant l'une des revendications précédentes, caractérisée en ce qu'elle comporte une ou plusieurs bandes (8, 9, 11, 12) de matériau à pulvériser constituées chacune de deux ou plusieurs matériaux différents.

10.- Cathode de pulvérisation suivant l'une quelconque des revendications précédentes, caractérisée en ce qu'elle comporte un système de refroidissement consistant en un conduit (27) à section fermée accolé à la cible (8, 9, 10, 11, 12, 13, 14, 15).

11.- Cathode de pulvérisation suivant la revendication 10, caractérisée en ce que le système de refroidissement présente une surface d'échange (25) avec le fluide de refroidissement plus grande que la surface de la cible (8, 9, 10, 11, 12, 13, 14, 15) elle-même.

**Patentansprüche**

1. Zerstäubungskatode (1), mit einem von einem elektrisch leitenden nicht-magnetischen Material gebildeten Aufbau (18, 20), auf dem mehrere Bänder (8, 9, 11, 12) von zu zerstäubendem Material in zumindest zwei definierten Ebenen festgelegt sind, Mitteln (3) zur Ermöglichung einer Verbindung der Kathode (1) mit einer elektrischen Stromquelle und mit Magnetmitteln (17, 19, 21, 22, 23), die derart angeordnet sind, dass sich das erzeugte elektrische Feld in der Nähe der Oberfläche der Bänder (8, 9, 11, 12) des zu zerstäubenden Materials auf deren gesamter Länge schliesst, dadurch gekennzeichnet, dass in jeder Ebene zumindest zwei Bänder (8, 9) des zu zerstäubenden Materials nebeneinander angeordnet, sämtliche Bänder des zu zerstäubenden Materials (8, 9, 11, 12) mit ihren Enden zur Erzielung einer einzigen kontinuierlichen und geschlossenen Bahn (8, 9, 10, 11, 12, 13, 14, 15) in R7eihe miteinander verbunden und Magnetmittel (17, 19, 21, 22, 23, 31) in den Verbindungszonen zwischen den Bändern (8, 9, 11, 12) des zu zerstäubenden Materials angeordnet sind, derart, dass sich ein begrenztes, fortlaufendes Magnetfeld der kontinuierlichen Bahn (8, 9, 10, 11, 12, 13, 14, 15) des zu zerstäubenden Materials überlagert.

2. Zerstäubungskathode nach Anspruch 1, dadurch gekennzeichnet, dass die Bänder (8, 9, 11, 12) des zu zerstäubenden Materials jeweils mit von den Magnetmitteln (17, 19, 21, 22, 23) der anderen Bänder (8, 9, 11, 12) des zu zerstäubenden Materials gesonderten Magnetmitteln (17, 19, 21, 22, 23) versehen sind.

3. Zerstäubungskathode nach einem der Ansprüche 1 und 2, dadurch gekennzeichnet, dass die Bänder (8, 9, 11, 12) des zu zerstäubenden Materials in zwei parallelen Ebenen angeordnet sind.

4. Zerstäubungskathode nach einem der Ansprüche 1 und 2, dadurch gekennzeichnet, dass die Bänder (8, 9, 11, 12) des zu zerstäubenden Materials in zwei sich schneidenden Ebenen angeordnet sind.

5. Zerstäubungskathode, nach einem der vorhergehenden Ansprüche, dadurch gekennzeichnet, dass zwei Bänder (8, 9) des zu zerstäubenden Materials in jeder Ebene angordnet sind.

6. Zerstäubungskathode nach einem der Ansprüche 1 bis 4, dadurch gekennzeichnet, dass mehr als zwei Bänder (8, 9) des zu zerstäubenden Materials in jeder Ebene angeordnet sind.

7. Zerstäubungskathode nach einem der vorhergehenden Ansprüche, dadurch gekennzeichnet, dass sie eines oder mehrere Bänder (47, 48, 49, 50) des zu zerstäubenden Materials umfasst, die von einem von dem der anderen Bänder (8, 9, 11, 12) unterschiedlichen Material gebildet sind.

8. Zerstäubungskathode nach einem der Ansprüche 1 bis 6, dadurch gekennzeichnet, dass sie in jeder Ebene eines oder mehrere Bänder (47, 48, 49, 50) des zu zerstäubenden Materials umfasst, die von einem von dem der anderen Bänder (8, 9, 11, 12) unterschiedlichen Material gebildet sind.

9. Zerstäubungskathode nach einem der vorhergehenden Ansprüche, dadurch gekennzeichnet, dass sie eines oder mehrere Bänder (8, 9, 11, 12) des zu zerstäubenden Materials umfasst, die jeweils von zwei oder mehreren verschiedenen Materialien gebildet sind.

10. Zerstäubungskathode nach einem der vorhergehenden Ansprüche, dadurch gekennzeichnet, dass sie ein Kühlsystem umfasst, das aus einer der Kollektorelektrode (8, 9, 10, 11, 12, 13, 14, 15) zugeordneten Leitung (27) mit geschlossenem Querschnitt besteht.

11. Zerstäubungskathode nach Anspruch 10, dadurch gekennzeichnet, dass das Kühlsystem eine Austauschfläche (25) mit dem Kühlmedium darbietet, die grösser als die Oberfläche der Kollektorelektrode (8, 9, 10, 11, 12, 13, 14, 15) selbst ist.

**Claims**

1. A sputtering cathode (1) comprising a structure (18, 20) made of a nonmagnetic electrically conductive material on which are fastened several strips (8, 9, 11, 12) of material to be sputtered which are situated in at least two different planes, means (3) enabling the cathode (1) to be connected to a source of electric current, and magnetic means (17, 19, 21, 22, 23) arranged so that the magnetic field generated is closed up in the vicinity of the surface of the strips (8, 9, 11, 12) of material to be sputtered, over the entire length of the latter, characterized in that in each plane at least two strips (8, 9) of material to be sputtered are arranged side by side, all the strips (8, 9, 11, 12) of material to be sputtered being connected together in series at their ends so as to form a single continuous, closed track (8, 9, 10, 11, 12, 13, 14, 15), magnetic means (17, 19, 21, 22, 23, 31) being arranged in the connecting regions between the strips (8, 9, 11, 12), with the result that a continuous magnetic confinement zone is superposed on the continuous track (8, 9, 10, 11, 12, 13, 14, 15) of material to be sputtered.

2. The sputtering cathode as claimed in claim 1, characterized in that the strips (8, 9, 11, 12) of material to be sputtered are each equipped with magnetic means (17, 19, 21, 22, 23) which are distinct from the magnetic means (17, 19, 21, 22, 23) of the other strips (8, 9, 11, 12) of material to be sputtered.

3. The sputtering cathode as claimed in any of claims 1 and 2, characterized in that the strips (8, 9, 11, 12) of material to be sputtered are situated in two parallel planes.

4. The sputtering cathode as claimed in claims 1 and 2, characterized in that the strips (8, 9, 11, 12) of material to be sputtered are situated in two secant planes.

5. The sputtering cathode according to any of the preceding claims, characterized in that two strips (8, 9) of material to be sputtered are arranged in each plane.

6. The sputtering cathode as claimed in any of claims 1 to 4, characterized in that more than two strips (8, 9) of material to be sputtered are arranged in each plane.

7. The sputtering cathode according to any of the preceding claims, characterized in that it comprises one or more strips (47, 48, 49, 50) of material to be sputtered, which consist of a material different from that of the remaining strips (8, 9, 11, 12).

8. The sputtering cathode as claimed in any of claims 1 to 6, characterized in that, in each plane, it comprises one or more strips (47, 48, 49, 50) of material to be sputtered which consist of a material different from that of the remaining strips (8, 9, 11, 12).

9. The sputtering cathode as claimed in according to any of the preceding claims, characterized in that it comprises one or more strips (8, 9, 11, 12) of material to be sputtered, each of which consists of two or more different materials.

10. The sputtering cathode according to any of the preceding claims, characterized in that it comprises a cooling system consisting of a closed-section conduit (27) adjoining the target (8, 9, 10, 11, 12, 13, 14, 15).

11. The sputtering cathode as claimed in claim 10, characterized in that the cooling system has a surface (25) for exchange with the cooling fluid which is larger than the surface of the target (8, 9, 10, 11, 12, 13, 14, 15) itself.

*Fig.1.*

*Fig.2.*

*Fig.3.*

EP 0 241 447 B1

Fig. 4

Fig. 5.

Fig. 6.

Fig. 7

Fig. 8.

Fig. 9.